(19) Europäisches Patentamt
European Patent Office
Office européen des brevets

(11) **EP 3 229 006 A1**

(12) **EUROPEAN PATENT APPLICATION**

(43) Date of publication:
**11.10.2017 Bulletin 2017/41**

(51) Int Cl.:
***G01M 99/00*** *(2011.01)*

(21) Application number: **16164583.3**

(22) Date of filing: **08.04.2016**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**MA MD**

(71) Applicant: **Ansaldo Energia Switzerland AG**
**5401 Baden (CH)**

(72) Inventors:
• **SISTANINIA, Meisam**
  **5200 BRUGG (CH)**
• **KRAMER, Thomas F.**
  **5408 ENNETBADEN (CH)**
• **UGEL, Diego**
  **5436 WÜRENLOS (CH)**
• **LILLEY, Darrel**
  **5453 REMETSCHWIL (CH)**
• **MAHLER, Alexander**
  **8280 KREUZLINGEN (CH)**

(74) Representative: **Bernotti, Andrea et al**
**Studio Torta S.p.A.**
**Via Viotti, 9**
**10121 Torino (IT)**

(54) **METHOD FOR DETERMINATION OF FATIGUE LIFETIME CONSUMPTION OF AN ENGINE COMPONENT**

(57) Disclosed is a method for the determination of fatigue lifetime consumption of an engine component, the method comprising defining a reference thermal load cycle, the reference thermal load cycle being characterized by a reference load cycle amplitude and a reference load cycle time, and determining a reference load cycle lifetime consumption. The method further comprises measuring a temperature of the engine component, determining a thermal load cycle based upon said temperature measurement, determining a load cycle amplitude, defined as the difference between the maximum measured temperature during the thermal load cycle and the minimum measured temperature during the thermal load cycle, determining a load cycle time, relating the load cycle time to the reference load cycle time, thereby determining a load cycle time factor, relating the load cycle amplitude to the reference load cycle amplitude, thereby determining a load cycle amplitude factor, combining the load cycle time factor and the load cycle amplitude factor into a combined load cycle factor, and determining a load cycle lifetime consumption dependent upon the combined load cycle factor.

Fig. 1

**Description**

TECHNICAL FIELD

The present disclosure relates to a method for the determination of fatigue lifetime consumption of an engine component as set forth in claim 1.

BACKGROUND OF THE DISCLOSURE

The increasing share of renewable energy sources in the power generation market requires more flexible operation of conventional thermal power plants. In particular gas turbine engines, whether operated in single cycle mode or in combined cycle power plants, are operated at strongly varying loads with large load gradients. This means, components of the gas turbine engine are exposed to an operation at strongly varying temperatures and pressures, and thus accurate quantification of low cycle fatigue is of increasing interest. In environments where a gas turbine engine is generally started and loaded up close to full load, and shut down from a load close to full load, mainly the cold start to full load load cycle and vice versa need to be considered. However, in operation regimes in which the load of a gas turbine engine is frequently changed between part load and full load, an increasing demand arises to reliably forecast and estimate the component lifetime consumption at load cycles with a lower amplitude than a cold start load cycle. This capability would enable power plant operators to avoid premature engine overhaul and replacement of parts, and unnecessary outages, while at the same time avoiding the risk of major engine damages and unplanned outages due to a delayed maintenance and component replacement, which all have a negative impact on the economics of operating the power plant. Thus, enabling a sufficiently reliable online forecast and estimating method for the lifetime of components of the gas turbine engine would enhance power plant economics considerably. Consequently, in order to enable power plant operators to operate the gas turbine engine, or a power plant, respectively, with suitable economics, an on-line lifetime counting tool is found desirable which processes data from an online field monitoring system and estimates lifetime consumption of the structural parts. The structural parts may be non-rotating static parts, such as casing members, or may be rotating rotor members. On-line fatigue life counting of components with high thermal inertia is found challenging, since the peak stresses of said components appear timely offset with the peak temperature of the working fluid of the turboengine.

Several approaches to the estimation of lifetime consumption are known in the art. US 3,584,507, for instance, discloses a method wherein the hot gas temperature and the shaft speed and accelerations are continuously measured and used as input for predefined embedded equations which correlate the measured engine parameters to lifetime consumption for creep, low cycle fatigue, and temperature shock fatigue. The equations applied are based on literature, and on analytical and empirical testing. Engine specific constants need to be determined, and may be updated based on field experience. The equation for creep correlates the consumed creep lifetime to the hot gas temperature and speed. The equation for low cycle fatigue correlates the incremental damage of a load cycle to the hot gas temperature and speed. The consumed low cycle fatigue life is determined by adding incremental low cycle fatigue damages due to the shaft acceleration cycles, which are identified and processed when they occur. The equation for thermal shock fatigue correlates the consumed thermal shock fatigue life to the rate of change of the hot gas temperature over time. The process includes measuring two engine parameters, hot gas temperature and shaft speed, an online incremental damage calculation by using pre-defined correlations for creep, low cycle fatigue and thermal shock fatigue, lifetime counting, storing of results, and according sensors and devices. It is apparent from the above that the method requires a high testing effort to establish the correlation functions between engine parameters and lifetime.

US 3,950,985 describes a method and devices for on-line monitoring of the creep and low cycle fatigue lifetime consumption of thermal power plant components with high thermal inertia. The method applies to components such as rotors, housings and piping of gas turbine engines, steam turbines, and steam boilers, which develop high thermally induced stresses during startup and cooldown. According to the therein disclosed method, the surface material temperature and an internal material temperature in certain cross-sections of the components are measured. The temperature difference between the measurement locations is applied to calculate the thermally induced stress. The method uses pre-defined correlations between stress, temperature and lifetime consumption to calculate the creep and low cycle fatigue lifetime increments, which are weighed and added together to an accumulated number of operation hours equivalent to operation hours at a reference load case. However, as the method relies on temperature measurements at certain locations of the component, the disclosed method only enables to determine lifetime consumption in sections of the component which are equipped with temperature measurement locations.

US 2010/0153080 discloses a method for lifetime monitoring and maintenance planning for turboengines. In a first step of the method, the lifetime of a component under consideration is calculated for a variety of damaging factors, under the assumption of a specific engine operation cycle, and a design phase lifetime model is obtained. In a second step, operation data of an engine are collected and the lifetime model is updated. In a further step, the model is further updated with results from an engine inspection. It is not apparent from the document if and how the model is applicable on-line. Further, it is not apparent how the model accounts for operating conditions different from the assumptions on which the design phase lifetime model is based. The method furthermore involves extensive measurement and processing of a large variety of engine operation data.

LINEOUT OF THE SUBJECT MATTER OF THE PRESENT DISCLOSURE

It is an object of the present disclosure to provide a method as initially mentioned. In a more specific aspect, the method shall allow an easy and reliable determination of fatigue lifetime consumption of an engine component. In a further aspect, the method shall be applicable on-line, that is, during the engine operation.

This is achieved by the subject matter described in claim 1.

Further effects and advantages of the disclosed subject matter, whether explicitly mentioned or not, will become apparent in view of the disclosure provided below.

Accordingly, disclosed is a method for the determination of fatigue lifetime consumption of an engine component, the method comprising defining a reference thermal load cycle, wherein the reference thermal load cycle is characterized by a reference load cycle amplitude and a reference load cycle time, and determining a reference load cycle lifetime consumption. The method further comprises measuring a temperature of the engine component, determining a thermal load cycle based upon said temperature measurement, determining a load cycle amplitude, defined as the difference between the maximum measured temperature during the thermal load cycle and the minimum measured temperature during the thermal load cycle, and determining a load cycle time. Subsequently, the load cycle time is related to the reference load cycle time, thereby determining a load cycle time factor, the load cycle amplitude is related to the reference load cycle amplitude, thereby determining a load cycle amplitude factor. The load cycle time factor and the load cycle amplitude factor are combined into a combined load cycle factor, and a load cycle lifetime consumption is determined dependent upon the combined load cycle factor.

In particular embodiments, one measurement of a temperature of the engine component is required and performed. In further embodiments, only temperature measurements on or close to a hot fluid exposed surface of the engine component is required and performed.

The load cycle lifetime consumption may be determined as an absolute value, or a relative value related to the reference load cycle lifetime consumption.

It is understood that a load cycle in this respect is to be understood as either increasing or decreasing the temperature. It is further understood that a load cycle time is a time in which the temperature increase, or decrease, respectively, of a thermal load cycle, or a certain percentage thereof, is achieved, and provides, in combination with the load cycle amplitude, a measure for the temperature gradient over time which the engine component is subjected to. In other words, the load cycle time measures how fast a temperature change occurs.

The method is accordingly based upon the finding that the incremental microstructural damage, or lifetime consumption, due to a thermal load cycle is for a given engine component primarily dependent upon the amplitude and gradient over time of a temperature change. Upon a temperature change at a component surface, the temperature change propagates into the component, driven by heat conduction, which causes a delayed temperature change inside the component. Thus, as a general rule of thumb, spatial temperature gradients and accordingly thermally induced stresses arise in the component. The temperature differences and thermally induced stresses are the higher, the higher the amplitude and the temperature gradient over time at the component surface are. For any component and for a reference thermal load cycle, a strain level or a reference load cycle lifetime consumption, representative of the incremental structural damage to the component material due to the thermally induced stresses, can be calculated. The reference load cycle in this respect is characterized by a reference load cycle amplitude of the temperature change and a reference load cycle time said temperature change, or a certain percentage thereof, takes. For any arbitrary load cycle, the load cycle being characterized by a load cycle temperature amplitude and load cycle time, or load cycle temperature gradient over time, respectively, a relative load cycle lifetime consumption, related to the reference load cycle lifetime consumption, can be determined dependent on the one hand on a ratio of the load cycle temperature amplitude and the reference load cycle temperature amplitude, and on the other hand on a ratio of the load cycle time and the reference load cycle time. That is, as will be readily appreciated, the lower the absolute temperature change of a load cycle is, and the slower the temperature change happens, the larger number of identical thermal load cycles would an engine component be able to withstand, that is, the lower the lifetime consumption of one load cycle would be.

Lifetime consumption may in this respect be understood as a consumption of a fraction of load cycles the engine component is able to withstand under defined reference conditions.

The load cycle amplitude and time factors may be defined as follows:

If $T_{R, min}$ is the minimum component material temperature of the reference thermal load cycle, $T_{R, max}$ is the maximum component material temperature of the reference thermal load cycle, $T_{min}$ is the minimum component material temperature of a thermal load cycle, and $T_{max}$ is the maximum component material temperature of a thermal load cycle, then the load cycle amplitude factor of the load cycle is defined as

$$R_T = (T_{max} - T_{min})/(T_{R,\,max} - T_{R,\,min})$$

It is understood, that $(T_{R,\,max} - T_{R,\,min})$ is the reference thermal load cycle amplitude, and $(T_{max} - T_{min})$ is the load cycle amplitude.

If $\Delta t_R$ is the time required in the reference thermal load cycle to increase or decrease the temperature about a certain percentage of the reference thermal load cycle amplitude, for instance 90%, and $\Delta t$ is the time to change the temperature within the load cycle about the same percentage of the load cycle amplitude, the load cycle time factor is defined as

$$R_{\Delta t} = \Delta t_R / \Delta t$$

The measurement of the temperature of the engine component, in an aspect of the present disclosure, is performed as a measurement of the material temperature of the engine component, and is in particular embodiments performed at or close to a critical location of the component, wherein critical may in more particular embodiments be related to crack initiation.

In an embodiment, an engine cold start and load up to full rated load is used as the reference load cycle.

The reference load cycle time may in certain aspects be defined as a time in which the absolute temperature change of the reference thermal load cycle amounts to a specific percentage of the reference load cycle amplitude, and the load cycle time is defined as the time in which the measured temperature changes by the same percentage of the load cycle amplitude of the thermal load cycle.

The combined load cycle factor may in certain embodiments further take a load cycle mechanical stress factor into account. It is to this extent understood that the lifetime calculations for the reference thermal load cycle may also need to consider mechanical loads due to external forces, for instance due to pressure induced forces, and, where applicable, centrifugal forces, may need to consider changes of the mechanical load which come along with the temperature changes, and may moreover need to consider a base temperature. The mechanical stress factor may be determined to account for different mechanical stresses acting during a load cycle, and may be determined by virtue of measured turboengine operating data, like pressure, temperature, or rotational speed. It is understood, that rotational speed does not apply to turboengine stator elements. Further, rotational speed is constant for heavy duty stationary power plant turboengines, and will in this case not influence the mechanical stress factor in terms of fatigue. Moreover, in particular in gas turbine engines temperature and pressure changes are generally correlated. In this specific case, the load cycle mechanical stress factor may be expressed as a function of the load cycle amplitude factor. It is presumed that the skilled person will generally be familiar with techniques and methods for scaling the influence of mechanical stress and mechanical stress cycles on the lifetime of an engine component.

The combined load cycle factor is in specific embodiments determined as

$$X = R_T \cdot R_{\Delta t}{}^{a \,\cdot\, R_T - b} \cdot R_F.$$

X represents the combined load cycle factor, $R_T$ represents the load cycle amplitude factor, $R_{\Delta t}$ represents the load cycle time factor, and $R_F$ represents the load cycle mechanical stress factor. a and b are consants; for instance, in particular embodiments a equals 0.5 and b equals 0.25. The load cycle mechanical stress factor may, if no additional information is available, be set to 1, or may be expressed as a function of the load cycle amplitude factor.

In a further instance of the method, a reference number of thermal load cycles is determined which equals the number of reference thermal load cycles until a crack is initiated in the engine component, a load cycle count factor is determined as a function of the combined load cycle factor, wherein the load cycle count factor is defined as the lifetime consumption of the load cycle under consideration, divided by the lifetime consumption of the reference load cycle, and the load cycle count factors of all load cycles during an engine component lifetime are summed up, thereby determining a cumulated load cycle consumption. It is presumed in this respect that the skilled person is familiar with the determination of a number of pre-determined load cycles until a crack is initiated in any given engine component. For an instance, while not limiting, this may be achieved by finite element calculations.

The load cycle count factor may be represented as

$$R_N = N_R/N,$$

wherein $R_N$ represents the load cycle count factor, N represents the number of thermal load cycles with a specific load cycle amplitude and load cycle time to crack initiation, and $N_R$ represents the number of reference thermal load cycles to crack initiation,

In a more specific instance, the method comprises determining a residual load cycle lifetime expectation as the difference between the reference number of thermal load cycles and the cumulated load cycle consumption. In another more specific aspect, the method comprises determining a relative lifetime consumption as a ratio of the cumulated load cycle consumption divided by the reference number of thermal load cycles.

The load cycle count factor is according to certain specific aspects of the present disclosure determined as

$$R_N = N_R/N = R_S^{-1/c},$$

wherein $R_N$ represents the load cycle count factor, N represents the number of thermal load cycles to crack initiation with a specific load cycle amplitude and load cycle time, $N_R$ represents the number of reference thermal load cycles to crack initiation, $R_S$ is a strain ratio which is determined as a function of the combined load cycle factor, and c is a material parameter. The above formula is derived from the Coffin-Manson equation. The material parameter c is the fatigue ductility exponent or Coffin-Manson exponent. It commonly lies in a range $-0.7 \leq c \leq -0.5$ for ductile metals. It is noted that according to the present disclosure the strain ratio is determined as a function of the above-defined combined load cycle factor. For instance, the load cycle strain ratio is expressed in a polynomial form of the combined load cycle factor. For a more specific instance, the load cycle strain ratio is expressed as a first order polynomial of the combined load cycle factor.

In certain instances, the engine component is a component of a gas turbine engine, and the reference thermal load cycle is a load cycle from cold start to full load of the gas turbine engine at a maximum load gradient.

In still further instances, the method is applied on-line, and in particular permanently during operation of the engine. The health status of the engine component may thus permanently be supervised, and maintenance may be scheduled as economically feasible.

It is understood that the features and embodiments disclosed above may be combined with each other. It will further be appreciated that further embodiments are conceivable within the scope of the present disclosure and the claimed subject matter which are obvious and apparent to the skilled person.

BRIEF DESCRIPTION OF THE DRAWINGS

The subject matter of the present disclosure is now to be explained in more detail by means of selected exemplary embodiments shown in the accompanying drawings. The figures show

Fig. 1    a flow diagram illustrating an exemplary mode of performing the method as disclosed above;
Fig. 2    a diagram illustrating the correlation between the combined load cycle factor and the strain ratio for a first exemplary engine component; and
Fig. 3    a diagram illustrating the correlation between the combined load cycle factor and the strain ratio for a second exemplary engine component.

It is understood that the drawings are highly schematic, and details not required for instruction purposes may have been omitted for the ease of understanding and depiction. It is further understood that the drawings show only selected, illustrative embodiments, and embodiments not shown may still be well within the scope of the herein disclosed and/or claimed subject matter.

EXEMPLARY MODES OF CARRYING OUT THE TEACHING OF THE PRESENT DISCLOSURE

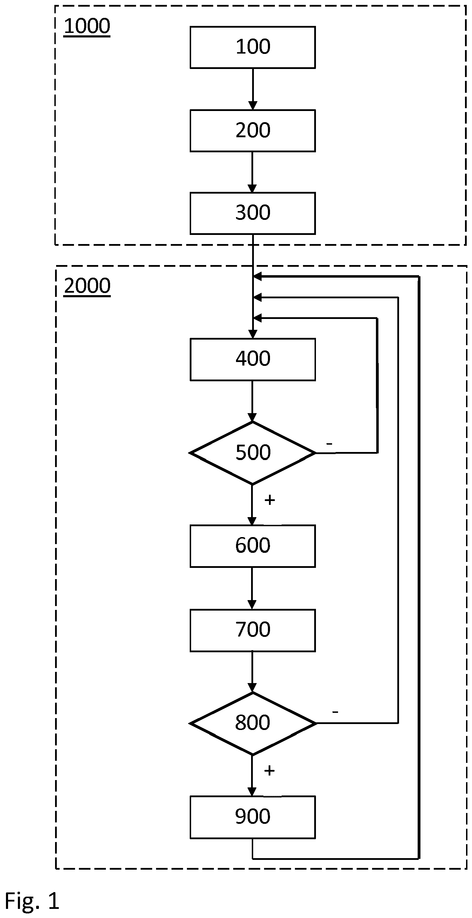

With reference to figure 1, an exemplary mode of carrying out the method as described above is lined out in more detail. In a first step 100, calculations for an engine component and a reference load cycle are performed. The reference load cycle is for instance a cold start of a gas turbine engine, and loading up the gas turbine engine to rated full power with the maximum load gradient for the gas turbine engine, or for the gas turbine engine when operated in a combined cycle power plant and the combined cycle power plant is loaded up at a maximum load gradient. These calculations may include computing the stresses in the engine component which arise due to the temperature differences within the material of the engine component. With this knowledge, a reference number of load cycles until a crack is initiated in the engine component can be derived. In a next step 200, said calculation may be repeated for a variety of load cycles in which the load cycle amplitude and load cycle time are varied. The number of load cycles until crack initiation may be computed for each of the load cycles. Generally, the results of said computations may be represented dependent on the combined load cycle factor. In particular, the strain ratio for each load cycle, wherein the strain ratio is given by

$$R_S = (N/N_R)^c,$$

wherein N represents the number of thermal load cycles to crack initiation with a specific load cycle amplitude and load cycle time, $N_R$ represents the number of reference thermal load cycles to crack initiation, $R_S$ is a strain ratio which is determined as a function of the combined load cycle factor, and c is the fatigue ductility exponent or Coffin-Manson exponent, which is a material specific parameter, which may also depend on the absolute temperature of the material. In a following step 300 a correlation function between, for instance, the strain ratio and the combined load cycle factor is developed. Such, the strain factor may be represented as $R_S = R_S (X)$, wherein X is the combined load cycle factor.

It is noted that steps 100 through 300 are generally performed off-line. The following steps will be performed on-line, while an engine is running. Thus, the exemplarily shown method may be considered as comprising two modules, an offline module 1000 and an on-line module 2000. In the on-line module, in a first step 400 of the on-line module 2000, a temperature of the engine component is measured. Based upon consecutive temperature measurements of thr component material temperature, as lined out above, in step 500 a decision is taken whether a thermal load cycle was initiated, and whether said thermal load cycle is completed, or not. If no thermal load cycle was completed, steps 400 and 500 will be repeated. If a thermal load cycle was completed, the combined load cycle factor will be calculated in step 600 based upon the measured load cycle amplitude and load cycle time. Further, in step 600 the strain factor and subsequently the load cycle count factor for the load cycle are computed. In step 700, all load cycle count factors during the lifetime of the engine component are summed up and constitute a cumulated load cycle consumption. In step 800, it is verified whether the cumulated load cycle consumption is larger than the reference number of thermal load cycles, which equals the number of reference thermal load cycles until a crack is initiated. If this is not the case, the on-line module 2000 starts again at step 400. If the cumulated load cycle consumption is larger than the reference number of thermal load cycles, an event or warning may be generated in step 900. The on-line module starts again at step 400. It is appreciated that step 900 may be initiated before the cumulative load cycle consumption actually reaches the reference number of thermal load cycles, such that a power plant operator might schedule a plant outage well before an actual damage occurs.

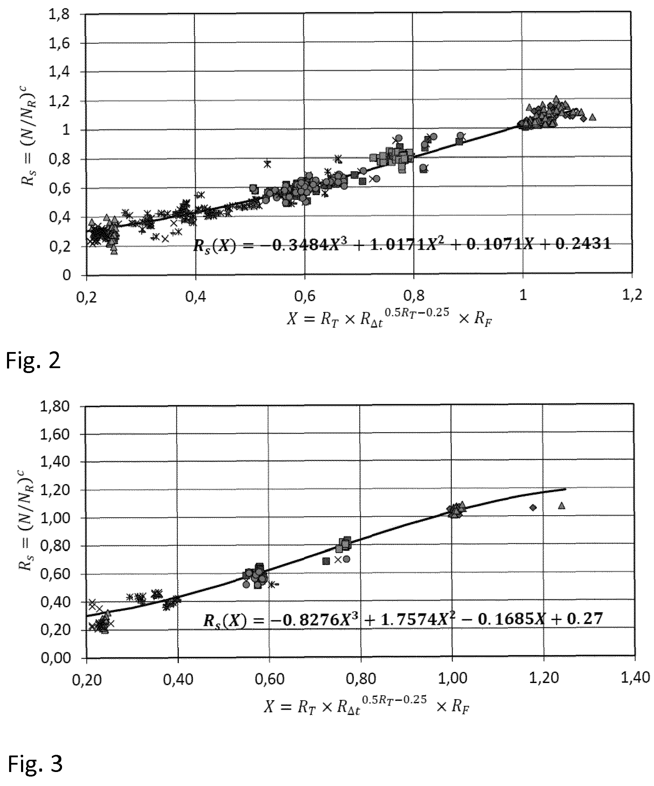

Figures 2 and 3 depict the correlation between the strain ratio $R_S$ and the combined load cycle factor X for two exemplary engine components. The data points show the results from numerical simulations, while the lines represent the function applied as a correlation in step 600 above. As is seen, an excellent fit of the simulation points and the correlation function results with a third order polynomial. As is furthermore seen, even with a first order polynomial a fairly good fit would be achieved. As is apparent, the correlation varies with different engine component geometries, but fits excellent for a given engine component.

While the subject matter of the disclosure has been explained by means of exemplary embodiments, it is understood that these are in no way intended to limit the scope of the claimed invention. It will be appreciated that the claims cover embodiments not explicitly shown or disclosed herein, and embodiments deviating from those disclosed in the exemplary modes of carrying out the teaching of the present disclosure will still be covered by the claims.

**Claims**

1. A method for the determination of fatigue lifetime consumption of an engine component, the method comprising defining a reference thermal load cycle,
   the reference thermal load cycle being **characterized by** a reference load cycle amplitude and a reference load cycle time, and determining a reference load cycle lifetime consumption,
   **characterized in that** the method further comprises
   measuring a temperature of the engine component,
   determining a thermal load cycle based upon said temperature measurement,
   determining a load cycle amplitude, defined as the difference between the maximum measured temperature during the thermal load cycle and the minimum measured temperature during the thermal load cycle, determining a load cycle time,
   relating the load cycle time to the reference load cycle time, thereby determining a load cycle time factor,

relating the load cycle amplitude to the reference load cycle amplitude, thereby determining a load cycle amplitude factor,

combining the load cycle time factor and the load cycle amplitude factor into a combined load cycle factor, and determining a load cycle lifetime consumption dependent upon the combined load cycle factor.

2. The method according to the preceding claim, **characterized in that** the reference load cycle time is defined as a time in which the absolute temperature change of the reference thermal load cycle amounts to a specific percentage of the reference load cycle amplitude, and the load cycle time is defined as the time in which the measured temperature changes by the same percentage of the load cycle amplitude of the thermal load cycle.

3. The method according to any of the preceding claims, **characterized in that** the combined load cycle factor further takes a load cycle mechanical stress factor into account.

4. The method according to any of the preceding claims, **characterized in that** the combined load cycle factor is determined as

$$ X = R_T \cdot R_{\Delta t}{}^{a \cdot R_T - b} \cdot R_F, $$

wherein X represents the load factor, $R_T$ represents the load cycle amplitude factor, a and b are constants, $R_{\Delta t}$ represents the load cycle time factor, and $R_F$ represents the load cycle mechanical stress factor.

5. The method according to the preceding claim, **characterized in that** a equals 0.5 and b equals 0.25.

6. The method according to any of the preceding claims, **characterized in**
determining a reference number of thermal load cycles which equals the number of reference thermal load cycles until a crack is initiated in the engine component,
determining a load cycle count factor based upon the combined load cycle factor, wherein the load cycle count factor is defined as the load cycle lifetime consumption divided by the reference load cycle lifetime consumption,
and summing up the load cycle count factors of all load cycles during an engine component lifetime, thereby determining a cumulated load cycle consumption.

7. The method according to the preceding claim, **characterized in** determining a residual load cycle lifetime expectation as the difference between the reference number of thermal load cycles and the cumulated load cycle consumption.

8. The method according to any of the two preceding claims, **characterized in** determining a relative lifetime consumption as a ratio of the cumulated load cycle consumption divided by the reference number of thermal load cycles.

9. The method according to any of the three preceding claims, **characterized in that** the load cycle count factor is determined as

$$ R_N = N_R/N = R_S{}^{-1/c}, $$

wherein $R_N$ represents the load cycle count factor, N represents the number of thermal load cycles with a specific load cycle amplitude and load cycle time to crack initiation, $N_R$ represents the number of reference thermal load cycles to crack initiation, $R_S$ is a strain ratio which is determined as a function of the combined load cycle factor, and c is a material parameter.

10. The method according to the preceding claim, **characterized in that** the load cycle strain ratio is expressed in a polynomial form of the combined load cycle factor.

11. The method according to the preceding claim, **characterized in that** the load cycle strain ratio is expressed as a first order polynomial of the combined load cycle factor.

12. The method according to any of the preceding claims, **characterized in that** the engine component is a component of a gas turbine engine, and the reference thermal load cycle is a load cycle from cold start to full load of the gas turbine engine at a maximum load gradient.

13. The method according to any of the preceding claims, **characterized in** applying the method on-line.

Fig. 1

$$R_s(X) = -0.3484X^3 + 1.0171X^2 + 0.1071X + 0.2431$$

$$X = R_T \times R_{\Delta t}^{\,0.5R_T - 0.25} \times R_F$$

Fig. 2

$$R_s(X) = -0.8276X^3 + 1.7574X^2 - 0.1685X + 0.27$$

$$X = R_T \times R_{\Delta t}^{\,0.5R_T - 0.25} \times R_F$$

Fig. 3

Europäisches
Patentamt

European
Patent Office

Office européen
des brevets

## EUROPEAN SEARCH REPORT

Application Number

EP 16 16 4583

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2014/192837 A1 (BUCHHOLZ BJÖRN [DE]) 10 July 2014 (2014-07-10) * paragraph [0047]; claim 1 * * paragraph [0047] * | 1-12 | INV. G01M99/00 |
| X | US 5 967 660 A (AKPAN EDWARD [US] ET AL) 19 October 1999 (1999-10-19) * claim 1 * | 1 | |
| X | SONG ET AL: "Thermal fatigue on pistons induced by shaped high power laser. Part I: Experimental study of transient temperature field and temperature oscillation", INTERNATIONAL JOURNAL OF HEAT AND MASS TRANSFER, PERGAMON PRESS, GB, vol. 51, no. 3-4, 7 January 2008 (2008-01-07), pages 757-767, XP022411843, ISSN: 0017-9310, DOI: 10.1016/J.IJHEATMASSTRANSFER.2007.04.035 * abstract; figure 8 * | 1,13 | |
| X | CN 103 344 511 A (BEIJING INST TECHNOLOGY) 9 October 2013 (2013-10-09) * claim 1 * | 1,3 | TECHNICAL FIELDS SEARCHED (IPC) G01M |

The present search report has been drawn up for all claims

| Place of search | Date of completion of the search | Examiner |
|---|---|---|
| The Hague | 21 September 2016 | Vytlacilová, Lenka |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 16 16 4583

This annex lists the patent family members relating to the patent documents cited in the above-mentioned European search report.
The members are as contained in the European Patent Office EDP file on
The European Patent Office is in no way liable for these particulars which are merely given for the purpose of information.

21-09-2016

| Patent document cited in search report | Publication date | Patent family member(s) | | Publication date |
|---|---|---|---|---|
| US 2014192837 A1 | 10-07-2014 | EP | 2724141 A2 | 30-04-2014 |
| | | US | 2014192837 A1 | 10-07-2014 |
| | | WO | 2013026500 A2 | 28-02-2013 |
| US 5967660 A | 19-10-1999 | CA | 2254534 A1 | 22-06-1999 |
| | | DE | 19856858 A1 | 01-07-1999 |
| | | GB | 2332747 A | 30-06-1999 |
| | | US | 5967660 A | 19-10-1999 |
| CN 103344511 A | 09-10-2013 | NONE | | |

EPO FORM P0459

For more details about this annex : see Official Journal of the European Patent Office, No. 12/82

**EP 3 229 006 A1**

**Patent documents cited in the description**

- US 3584507 A
- US 3950985 A
- US 20100153080 A